(19) Europäisches Patentamt

European Patent Office

Office européen des brevets

(11) Veröffentlichungsnummer : **0 334 209 B1**

(12) **EUROPÄISCHE PATENTSCHRIFT**

(45) Veröffentlichungstag der Patentschrift :
**10.06.92 Patentblatt 92/24**

(21) Anmeldenummer : **89104720.1**

(22) Anmeldetag : **16.03.89**

(51) Int. Cl.⁵ : **H01S 3/06,** H01S 3/19

(54) **Laserdiode zur Erzeugung streng monochromatischer Laserstrahlung.**

(30) Priorität : **22.03.88 DE 3809609**

(43) Veröffentlichungstag der Anmeldung :
**27.09.89 Patentblatt 89/39**

(45) Bekanntmachung des Hinweises auf die
Patenterteilung :
**10.06.92 Patentblatt 92/24**

(84) Benannte Vertragsstaaten :
**DE FR GB**

(56) Entgegenhaltungen :
**EP-A- 0 000 557
EP-A- 0 177 828
EP-A- 0 218 518
EP-A- 0 236 713
EP-A- 0 253 597**

(56) Entgegenhaltungen :
**IEE PROCEEDINGS SECTION A à I, Band 132,
Nr. 2, Teil J, Seiten 133-135, Old Woking, Surrey, GB; R. SCHIMPE: "Designconsiderations
of the metal-clad ridge-waveguide laser with
distributed feedback"**
**PATENT ABSTRACTS OF JAPAN, Band 8, Nr.
39 (E-228)[1476], 21. Februar 1984; & JP-A-58
196 084 (HITACHI SEISAKUSHO K.K.)15-
11-1983**
**ELECTRONICS LETTERS, Band 20, Nr. 6, März
1984, Seiten 225-226, London, GB; L.D. WEST-
BROOK et al.: "Continuous-wave operationof
1-5 mum distributed-feedback ridge-waveguide lasers"**

(73) Patentinhaber : **SIEMENS
AKTIENGESELLSCHAFT
Wittelsbacherplatz 2
W-8000 München 2 (DE)**

(72) Erfinder : **Baumann, Paul-Günther, Dipl.-Ing.
Altomünsterstrasse 16
W-8062 Langenrettenbach (DE)**
Erfinder : **Honsberg, Martin, Dipl.-Ing.
Erhardtstrasse 15
W-8000 München 5 (DE)**

**Beschreibung**

Die vorliegende Erfindung bezieht sich auf eine Laserdiode nach dem Oberbegriff des Patentanspruches 1.

Aus einer theoretischen Arbeit von R. F. Kazarinov, Fizika i Tekhnika Poluprovodnikov, Vol. 6, No. 7 (1972), S. 1359 ff. geht hervor, daß man mittels einer periodischen Struktur bei einer Halbleiter-Laserdiode eine Beeinflussung der Strahlungserzeugung erreichen kann dahingehend, daß diese Strahlung wenigstens zu einem hohen Grad monochromatisch ist. Eine solche Struktur wird heutigentags als DFB-Struktur (distributed feedback-structure) bezeichnet. Die Wirkungsweise dieser Struktur ist, "Bragg"-Reflexionen zu bewirken. Die Struktur ist eine periodische Struktur, deren Periode mit der Wellenlänge der Laserstrahlung im Halbleitermaterial korrespondiert.

Eine Realisierung einer Laserdiode mit einer derartigen DFB-Struktur ist von Walpole und anderen, in Applied Physics Letters Bd. 29, Nr. 5 (September 1976), Seiten 307 ff. beschrieben. Jüngeren Datums sind solche Laserdioden mit DFB-Struktur von Nelson in IEEE Proc. Bd. 132 (Februar 1985, Seite 12 ff.) und von Liau in Applied Physics Letters, Bd. 46 (Februar 185), Seiten 221 ff. beschrieben worden.

Walpole beschreibt eine Laserdiode mit einem Steg (ridge), der zur Strominjektion auf seiner Oberfläche eine Elektrode besitzt. Diese Oberfläche hat eine wie dargestellte Wellenform (gratings) mit der von Kazarinov angegebenen Periodizität. Die Laserdiode von Walpole hat einen double-hetero-structure-Aufbau, wie er z.B. in dem US-Patent (43 52 187) angegeben ist.

Die DFB-Struktur befindet sich bei Nelson zwischen zwei Schichten des double-hetero-Schicht-Aufbaus. Diese Plazierung bedingt, daß die Epitaxie der Abscheidung der aufeinanderfolgenden Schichten dieser double-hetero-structure dann unterbrochen werden muß, wenn die Wellenstruktur der DFB-Struktur in die Oberfläche der zu diesem Zeitpunkt obersten Schicht hineinzuätzen ist. Dieses Verfahren ist technologisch aufwendig und führt zu Schäden.

Um Schwierigkeiten zu vermeiden, die sich aus der Verbindung von Injektionselektrode und DFB-Struktur wie bei Walpole ergeben, hat Liau eine Laserdiode angegeben, bei der die Injektionselektrode aufgeteilt ist in zwei seitlich der Laserzone plazierte Elektrodenstreifen, zwischen denen sich als Streifen ausgebildet die DFB-Struktur befindet. Diese Struktur und die Elektroden liegen in praktisch ein und derselben Ebene und diese Struktur befindet sich oberhalb der laseraktiven Zone, so daß sie direkt auf die laseraktive Zone einwirken kann. Liau beseitigt damit diejenigen Störung, die bei Kombination einer DFB-Struktur mit der Injektionselektrode wie bei Walpole auftritt. Bei der Diode von Liau liegt aber der Nachteil vor, daß die Strominjektion in die laseraktive Zone von der Seite her erfolgt und Vorkehrungen erforderlich sind, die eine möglichst wirksame Einschnürung der Strominjektion bewirken, nämlich zum Erreichen einer solchen Stromeinengung, wie sie für Streifendiodenlaser bekannt ist.

Aufgabe der vorliegenden Erfindung ist es eine Halbleiter-Laserdiode mit Doppel-Heterostruktur und DFB-Struktur anzugeben, die besonders einfach herzustellen ist und die dennoch bzw. außerdem eine besonders intensive Wirkung der DFB-Struktur im Hinblick auf monochromatische Eigenschaft der erzeugten Laserstrahlung aufweist.

Diese Aufgabe wird mit einer Halbleiter-Laserdiode nach dem Anspruch 1 gelöst und weitere Ausgestaltungen und Weiterbildungen der Erfindung gehen aus den Unteransprüchen hervor.

Eingangs der vorliegenden Beschreibung sind die Probleme angegeben, die bisherige Ausgestaltungen einer Halbleiter-Laserdiode mit DFB-Struktur mit sich brachten. Für die vorliegende Erfindung ist von der Überlegung ausgegangen worden, daß es notwendig ist, das Epitaxieverfahren für die Herstellung der Doppelhetero-Schichtstruktur ohne Unterbrechung auszuführen, d.h. ohne Unterbrechung die aufeinanderfolgenden Schritte zur epitaxialen Abscheidung der aufeinander folgenden Schichten durchzuführen. In die Oberfläche bzw. in die oberflächennahe Zone der "obersten" confinement-Schicht der Doppelhetero-Schichtstruktur wird die DFB-Struktur eingebracht.

Bei der Erfindung wird die DFB-Struktur z.B. mittels Ionenätzen in Verbindung mit holographischer Fotolithografie hergestellt. Auch andere Ätzverfahren können angewendet werden. Eine solche Struktur wird auch als DFB-Gitter (grating) bezeichnet.

Für eine Galliumarsenid-Laserdiode ist die Gitterperiode der DFB-Struktur für die dritte Bragg-Ordnung 375 nm groß, wobei die Abmessung zwischen "Wellenberg" und "Wellental" den technologischen Gegebenheiten entsprechend möglichst groß gemacht wird, z.B. 140 nm beträgt.

Die DFB-Struktur wird hier also erst dann ausgeführt, nachdem sämtliche Epitaxieschritte zur Herstellung der Doppelhetero-Schichtstruktur durchgeführt worden sind. Im Anschluß an die Herstellung der DFB-Struktur erfolgt eine selektive, dünnschichtige, sogenannte "flache" Dotierung lediglich der oberflächennahen Zone der DFB-Struktur. Bevorzugt wird eine p-dotierende Zinkdiffusion ausgeführt. Es kann gegebenenfalls von Vorteil sein, derartige Dotierung durch Implantation durchzuführen. Diese Zone hält eine hohe Dotierung größer als

$10^{18}/cm^3$ vorzugsweise größer $10^{19}/cm^3$.

Diese insbesondere p-dotierte Zone bewirkt, daß zusammen mit der noch zu beschreibenden Metallisierung ein ohmscher Kontaktübergang des Metall-Halbleiterkontakts erzielt wird. Es ist dies eine dem Prinzip nach übliche Maßnahme. Bei hinsichtlich der Reihenfolge der Dotierung umgekehrten Schichtenaufbau der Doppelhetero-Schichtstruktur ist diese Zone eine n-dotierte Zone, und zwar wiederum mit erhöhter Dotierung zum Erreichen eines möglichst weitgehend ohmschen Kontaktes.

Diese Zone mit hoher Dotierung zur Erzielung eines Metall-Halbleiterübergangs mit möglichst geringem Übergangswiderstand bestimmt für eine (lateral) gewinngeführte Laserdiode mit Streifengeometrie bekanntermaßen die Abmessungen des aktiven Streifens.

Eine besonders bevorzugte Ausführungsform einer erfindungsgemäßen Diode ist die einer BCRW- (bridge-contacted-ridge-waveguide) Laserdiode, wie sie z.B. in der EP-Offenlegungsschrift 0 236 713 beschrieben und dargestellt ist.

Wie dies in der älteren Anmeldung angegeben ist, wird für die Herstellung einer derartigen BCRW-Laserdiode noch ein weiterer Ätzprozeß durchgeführt, der diese bridge-Struktur, die der Kontaktierung und Stromzuführung dient, erzeugt.

Auf der DFB-Struktur ist erfindungsgemäß eine Metallisierungsbeschichtung vorgesehen. Diese Metallisierungsbeschichtung deckt z.B. die Welligkeit der DFB-Struktur vollständig zu, so daß die Laserdiode eine glatte Metallisierungsoberfläche in dem betreffenden Bereich besitzt. Diese Metallisierung der DFB-Struktur dient als eine der beiden Injektionselektroden der Laserdiode. Die zweite Elektrode ist im allgemeinen das Substrat mit dem Substratanschluß.

Der mittlere Abstand der DFB-Struktur von der laseraktiven Schicht der Laserdiode und damit der Abstand der Metallisierung von der laseraktiven Zone ist klein, nämlich kleiner als etwa 3 Wellenlängen der Laserstrahlung im Halbleitermaterial ist. Erfindungswesentlich ist, daß die schon oben beschriebene hochdotierte Zone, d.h. die an die Metallisierungs-Beschichtung angrenzende oberflächennahe Zone der hier obersten Schicht der Doppel-Heteroschichtstruktur derart geartet ist, daß sie keine starke Absorption für die Laserstrahlung bewirkt. Dies wird dadurch erreicht, daß für diese an die laseraktive Schicht der Doppel-Heteroschichtstruktur angrenzende "obere" Schicht, sie wird auch als confinement-Schicht bezeichnet, hinsichtlich des Materials so ausgewählt ist, daß auch bei der entsprechend hohen Dotierung der Bandabstand des Materials dieser confinement-Schicht wenigstens etwa 2 kT größer ist, als der Bandabstand des Materials der laseraktiven Schicht, so daß störende Absorption der Laserstrahlung ausgeschlossen ist. Bekanntermaßen ist für das Material dieser confinement-Schicht ein kleinerer Brechungsindex als für das Material der laseraktiven Schicht vorzusehen.

Für ein Gallium-Alumium-Arsenid-Materialsystem bekannten Aufbaus, im Regelfall mit einer laseraktiven Schicht bzw. -Zone aus Galliumarsenid ist diese erfindungsgemäße Vorschrift des obigen Abstandes mit etwa 400 nm gut erfüllt. Im bekannten Indium-Galliumarsenid-Phopshid-System ist ein (größerer) Abstand von 800 nm eine günstige Bemessung erfindungsgemäß zulässig sind für das Gallium-Arsenid-Materialsystem 750 nm bis etwa 200 nm und für das Indium-Gallium-Arsenid-Phosphid-Materialsystem 1500 nm bis etwa 400 nm.

Vergleichsweise zu den oben genannten z.B. 400 nm hat die vorzusehende "flache" Dotierungszone eine Dicke von bis zu ca. 100 nm. Die Höhe der Dotierung liegt im Regelfall bei $10^{19}$ oder vorzugsweise höher.

Nachfolgend wird die Erfindung anhand der Beschreibung der beigefügten Figuren näher erläutert.

Die Figuren 1 und 2 zeigen je einen Aufbau einer Doppelhetero-Schichtstruktur prinzipiell bekannter Art und zwar für einen Galliumarsenid-Laser und für einen Indium-Galliumarsenid-Phosphid-Laser. Die Darstellung der Figuren 1 und 2 enthalten aber auch schon die erfindungsgemäßen Bemessungen.

Die Figuren 3 und 4 zeigen konstruktive Ausführungsformen der Erfindung.

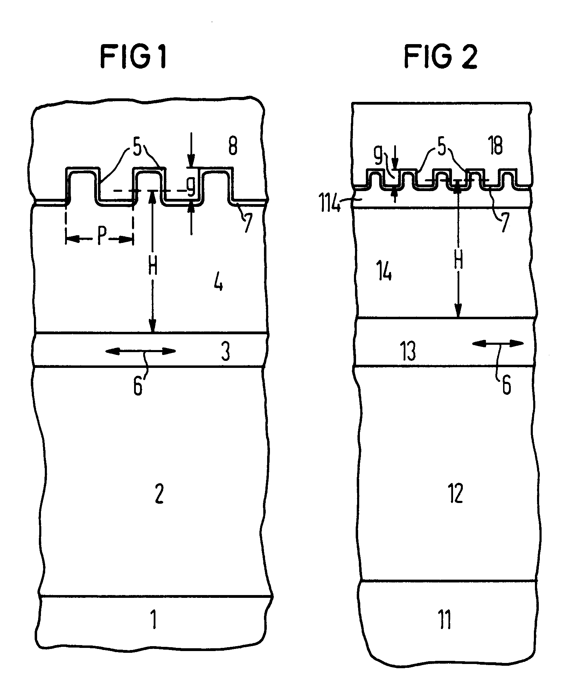

In Fig. 1 ist das Substrat aus beispielsweise Galliumarsenid mit 1 bezeichnet. Mit 2 ist die eine, "untere" confinement-Schicht aus n-Gallium-Aluminiumarsenid bezeichnet. Mit 3 ist die laseraktive Schicht aus Galliumarsenid angegeben und die für die Erfindung wesentliche "obere" confinement-Schicht aus p-Gallium-Aluminiumarsenid ist mit 4 bezeichnet. Mit 5 ist die (in der Oberfläche dieser Schicht 4 vorzusehende) periodische DFB-Struktur angegeben. Die Fig. 1 ist damit eine Seitenansicht eines Anteils des Körpers einer Laserdiode, in der die laseraktive Strahlung in Richtung des Doppelpfeiles 6 verläuft.

Mit 7 ist die oben erwähnte hochdotierte Schicht, z.B. Diffusionsschicht bezeichnet. Der mit H eingetragene Abstand ist der erfindungsgemäß innerhalb der oben angegebenen Grenzen einzuhaltende Abstand zwischen der Mittellage der DFB-Struktur 5 und der laseraktiven Schicht 3. Mit 8 ist die Metallisierungsbeschichtung z.B. aus Chrom-Gold bezeichnet. Der Doppelpfeil g gibt die Wellenhöhe und das Zeichen P gibt die Periodenlänge der DFB-Struktur an. Diese Länge P ist bei der 3. Bragg-Ordnung das 1,5fache der Wellenlänge der Laserstrahlung (6) und zwar im Material der laseraktiven Schicht 3.

Die Fig. 2 zeigt ein Substrat 11 aus z.B. Indiumphosphid, eine erste Schicht 12 aus n-Indiumphosphid, die laseraktive Schicht 13 aus Indium-Galliumarsenid-Phosphid, die confinement-Schicht 14 aus P-Indiumphosphid und die Metallisierungsbeschichtung 18. Die DFB-Struktur ist wieder mit 5 und die hochdotierte Zone mit 7 bezeichnet. Mit 114 ist eine zusätzliche P-Indium-Galliumarsenid-Phosphid-Schicht bezeichnet, wie sie für Indiumphosphid-Laser bekanntermaßen verwendet wird. Im Sinne der Erfindung gehört diese Schicht 114 zur Schicht 14, d.h. zur "oberen" confinement-Schicht.

Mit H ist wieder der erfindungsgemäß einzuhaltende Abstand angegeben.

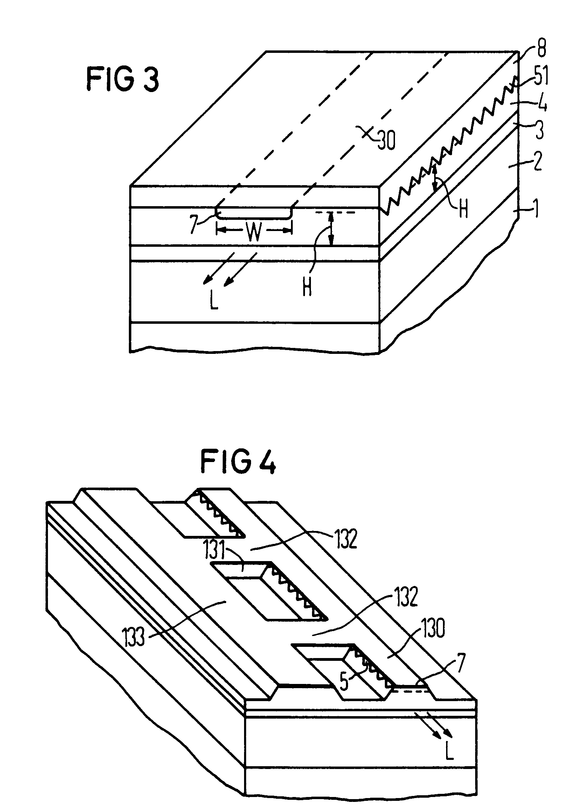

Fig. 3 zeigt einen konstruktiven Aufbau. In Fig. 3 sind für die Schichten die Bezugszeichen für das System Galliumarsenid verwendet. Für das System Indiumphosphid sind die entsprechenden Bezugszeichen der Fig. 2 einzusetzen. In der Fig. 3 ist anstelle einer Rechteck-Mäander-DFB-Struktur 5 eine Zick-Zack-DFB-Struktur 51 dargestellt. Dieser Unterschied der Ausführung kann im Einzelfall Vorteile bringen. Beide Ausführungsformen sind spezielle Ausführungsformen der Erfindung. Mit W ist die oben angegebene Breite der dünnen, hochdotierten Zone 7, der z.B. flach zinkdotierten Diffusionszone angegeben. Mit 30 ist auf die Fläche der Injektionswirkung eines zugeführten elektrischen Stromes auf die laseraktive Schicht 3 hingewiesen. Entsprechend lang und breit ist die darunterliegende Zone der Laser-Strahlungserzeugung in der laseraktiven Schicht 3. In der Darstellung der Fig. 3 tritt die Laserstrahlung durch die Pfeile L angedeutet aus dem Körper, bestehend aus der angegebenen Doppelhetero-Schichtstruktur 2, 3, 4, dem Substrat 1 und der Metallisierungsbeschichtung 8, aus.

Die Fig. 4 zeigt die oben schon erwähnte BCRW-Ausführungsform einer Laserdiode. Der laseraktive Streifen (ridge) ist mit 130 bezeichnet. Auch für die Fig. 4 sind die Bezeichnungen der Galliumarsenid-Laserdiode nach Fig. 1 angegeben. Entsprechend ausgetauscht wären die Bezugszeichen für eine Indiumphosphid-Diode anzugeben. Mit 131 ist eine "bridge"-Verbindung bezeichnet, deren Oberflächenmetallisierung eine elektrische Stromzuführungs-Leiterbahn zwischen der Anschluß-Metallisierung 133 und der Metallisierung 130 der Injektionselektrode der Laserdiode ist.

## Patentansprüche

1. Halbleiter-Laserdiode der Materialsysteme Gallium-Aluminium-Arsenid und Indium-Gallium-Arsenid-Phosphid mit einer Doppelhetero-Schichtstruktur (1,2,3,4,;11,12,13,14,114), mit einer DFB-Struktur (5), mit einer hochdotierten Zone (7) für ohmschen Kontakt und mit einer Kontaktmetallisierungsbeschichtung (8;18) auf der Doppelhetero-Schichtstruktur, wobei die DFB-Struktur ein Oberflächen-Schichtanteil derjenigen Schicht (4;14) der Doppelhetero-Schichtstruktur ist, die der Metallisierung zugewandt ist,
**gekennzeichnet dadurch,**
daß die Metallisierungsbeschichtung (8;18) auf der DFB-Struktur (5) vorgesehen ist,
daß sich angrenzend an diese Metallisierungsbeschichtung (8;18) die hochdotierte Zone (7) als dünnschichtige Zone innerhalb der DFB-Struktur (5) befindet und
daß das Material der Schicht (4), in der sich die hochdotierte Zone (7) befindet, so ausgewählt ist, daß in dieser hochdotierten Zone (7) keine etwa 50 cm$^{-1}$ übersteigende Absorption der Laserstrahlung (L) bewirkt ist.

2. Laserdiode nach Anspruch 1,
**gekennzeichnet dadurch,** daß es sich bei der hoch dotierten Zone um eine flach-dotierte Zone handelt.

3. Laserdiode nach Anspruch 1 oder 2,
**gekennzeichnet dadurch,** daß für das Gallium-Aluminium-Arsenid-System der Abstand (H) zwischen der Mittellage der DFB-Struktur (5) und der laseraktiven Schicht (3) etwa 400 nm bis 200 nm beträgt.

4. Laserdiode nach Anspruch 2 und 3,
**gekennzeichnet dadurch,** daß die Dicke der hoch dotierten Zone bis maximal etwa 100 nm beträgt.

5. Laserdiode nach Anspruch 1 oder 2,
**gekennzeichnet dadurch,** daß für das Indium-Gallium-Arsenid-phosphid-System der Abstand (H) zwischen der Mittellage der DFB-Struktur (5) und der laseraktiven Schicht (3) etwa 900 nm bis 400 nm beträgt.

6. Laserdiode nach einem der Ansprüche 1 bis 5,
**gekennzeichnet dadurch,** daß sie den Aufbau einer BCRW-Diode hat.

7. Laserdiode nach einem der Ansprüche 1 bis 5,
**gekennzeichnet dadurch,** daß sie einen Aufbau entsprechend einer Laserdiode in Planarausführung hat.

## Claims

1. Semiconductor laser diode of the material systems gallium-aluminium-arsenide and indium-gallium-arsenide-phosphide having a double-hetero layer structure (1, 2, 3, 4; 11, 12, 13, 14, 114), having a DFB structure (5), having a highly doped zone (7) for ohmic contact and having a contact metallisation coating (8; 18) on the double-hetero layer structure, in which the DFB structure is a surface layer portion of that layer (4; 14) of the double-hetero layer structure which is facing the metallisation,
characterised in that
the metallisation coating (8; 18) is provided on the DFB structure (5),
in that the highly doped zone (7) is located as thin-layer zone within the DFB structure (5) adjacent to said metallisation coating (8; 18), and
in that the material of the layer (4) in which the highly doped zone (7) is located is selected so that no absorption of the laser light (L) that exceeds approximately 50 cm$^{-1}$ is produced in said highly doped zone (7).

2. Laser diode according to Claim 1,
characterised in that the highly doped zone is a flat-doped zone.

3. Laser diode according to Claim 1 or 2,
characterised in that for the gallium-aluminium-arsenide system the distance (H) between the middle layer of the DFB structure (5) and the laser-active layer (3) is approximately 400 nm to 200 nm.

4. Laser diode according to Claim 2 and 3,
characterised in that the thickness of the highly doped zone is a maximum of approximately 100 nm.

5. Laser diode according to Claim 1 or 2,
characterised in that for the indium-gallium-arsenide-phosphide system the distance (H) between the middle layer of the DFB structure (5) and the laser-active layer (3) is approximately 900 nm to 400 nm.

6. Laser diode according to one of Claims 1 to 5,
characterised in that it has the structure of a BCRW diode.

7. Laser diode according to one of Claims 1 to 5,
characterised in that it has a structure in accordance with a laser diode of planar design.


## Revendications

1. Diode laser à semiconducteurs formée des systèmes de matériaux arseniure de gallium et d'aluminium et arseniure-phosphure d'indium et de gallium, comportant une double hétérostructure de couches (1,2,3,4; 11,12,13,14,114), possédant une structure DFB (5), une zone fortement dopée (7) pour un contact ohmique et un revêtement formé d'une métallisation de contact (8;18) sur la double hétérostructure de couches, la structure DFB constituant une partie superficielle de la couche (4;14) de la double hétérostructure de couches, qui est tournée vers la métallisation,
caractérisée par le fait
que le revêtement (8;18) formé de la métallisation est prévu sur la structure DFB (5),
que la zone fortement dopée (7) jouxte ce revêtement (8;18) formé par la métallisation et est présente sous la forme d'une zone à couche mince à l'intérieur de la structure DFB (5), et
que le matériau de la couche (4), dans laquelle est située la zone fortement dopée (7), est choisi de manière qu'aucune absorption, dépassant environ 50 cm$^{-1}$, du rayonnement laser (L) n'est réalisée dans cette zone fortement dopée (7).

2. Diode laser suivant la revendication 1,
caractérisée par le fait qu'en ce qui concerne la zone fortement dopée, il s'agit d'une zone dopée sur une faible profondeur.

3. Diode laser suivant la revendication 1 ou 2,
caractérisée par le fait que pour le système à arseniure de gallium et d'aluminium, la distance (H) entre la couche centrale de la structure DFB (5) et la couche (3) active pour l'effet laser est comprise entre environ 400 nm et 200 nm.

4. Diode laser suivant les revendications 2 et 3,
caractérisé par le fait que l'épaisseur de la zone fortement dopée est égale au maximum à environ 100 nm.

5. Diode laser suivant la revendication 1 ou 2,
caractérisée par le fait que pour le système à arseniure-phosphure d'indium et de gallium, la distance (H) entre la couche centrale de la structure DFB (5) et la couche (3) à effet laser est comprise entre environ 900 nm et 400 nm.

6. Diode laser suivant l'une des revendications 1 à 5,
caractérisée par le fait qu'elle possède la structure d'une diode BCRW.

7. Diode laser suivant l'une des revendications 1 à 5,
caractérisée par le fait qu'elle possède une structure correspondant à une diode laser dans la réalisation planar.

# FIG 1

# FIG 2

EP 0 334 209 B1

FIG 3

8
51
4
3
2
1

30

7
W
H
H
L

FIG 4

132
131
132
133
130
5
7
L

7